# DEMANDE DE BREVET EUROPEEN

(11) **EP 0 646 805 A1**
(43) Date de publication de la demande: **05.04.1995**
(21) Numéro de dépôt: 94410079.1
(22) Date de dépôt: 20.09.1994
(51) Int. Cl.: G01R 33/028

(54) **Détecteur angulaire de champ magnétique**

(30) Priorité: 23.09.1993 FR 9311810
(71) Demandeur: CROUZET Automatismes (Société Anonyme), F-25000 Valence (FR)
(72) Inventeur: Blain, Gérard, F-26120 Chabeuil (FR); Ngoagouni, Olivier, F-26000 Valence (FR)
(74) Mandataire: de Beaumont, Michel

(57) **Abrégé**

La présente invention concerne un détecteur angulaire de champ magnétique comprenant des capteurs à poutre fléchissante orthogonaux deux à deux. Chacun des capteurs (12-1...12-4) s'étend vers le centre d'un support (11) en forme de cadre. L'ensemble est formé par photolithogravure d'une plaquette de silicium.

## Description

La présente invention concerne le domaine des détecteurs angulaires. De tels détecteurs sont couramment utilisés pour déterminer la position en rotation d'un axe et peuvent faire appel à diverses grandeurs physiques. On connaît, par exemple, des détecteurs optiques, des détecteurs à potentiomètre, des détecteurs inductifs.

Une caractéristique commune que doivent avoir ces divers détecteurs est qu'ils ne doivent pas influer sur le mouvement de l'axe et notamment ne pas introduire de frottement. Les divers types de détecteurs connus ont chacun leurs avantages et leurs inconvénients. Par exemple, le système décrit dans la demande de brevet français 2677758 du 17.06.91 intitulée "capteur angulaire à transformateur différentiel" présente l'avantage d'une grande simplicité, d'une grande compacité et d'une bonne précision mais, comme tous les détecteurs de ce type, présente l'inconvénient de n'être sensible que dans une certaine plage angulaire autour d'une position d'équilibre.

Un objet de la présente invention est de prévoir un détecteur angulaire qui comme le détecteur de la demande de brevet français susmentionnée puisse être installé à l'extrémité d'un axe tournant.

Un autre objet de la présente invention est de prévoir un détecteur de dimensions particulièrement réduites.

Un autre objet de la présente invention est de prévoir un détecteur dont la sensibilité soit constante pour toute position angulaire.

Un autre objet de la présente invention est de prévoir un détecteur dont la mise en route ne nécessite pas d'opérations d'étalonnage complexes.

Un autre objet de la présente invention est de prévoir un détecteur qui puisse également servir de détecteur de choc.

Pour atteindre ces objets, la présente invention fait appel à des technologies de gravure de silicium initialement développées dans le cadre de la fabrication des semiconducteurs et également utilisées pour la fabrication de micro-capteurs en silicium. Plus particulièrement, la demande de brevet français 2644897 du 21 mars 1989 intitulée "Micromagnétomètre à poutre fléchissante" décrit un capteur de champ magnétique destiné à déterminer l'intensité (et non l'orientation) d'un champ magnétique.

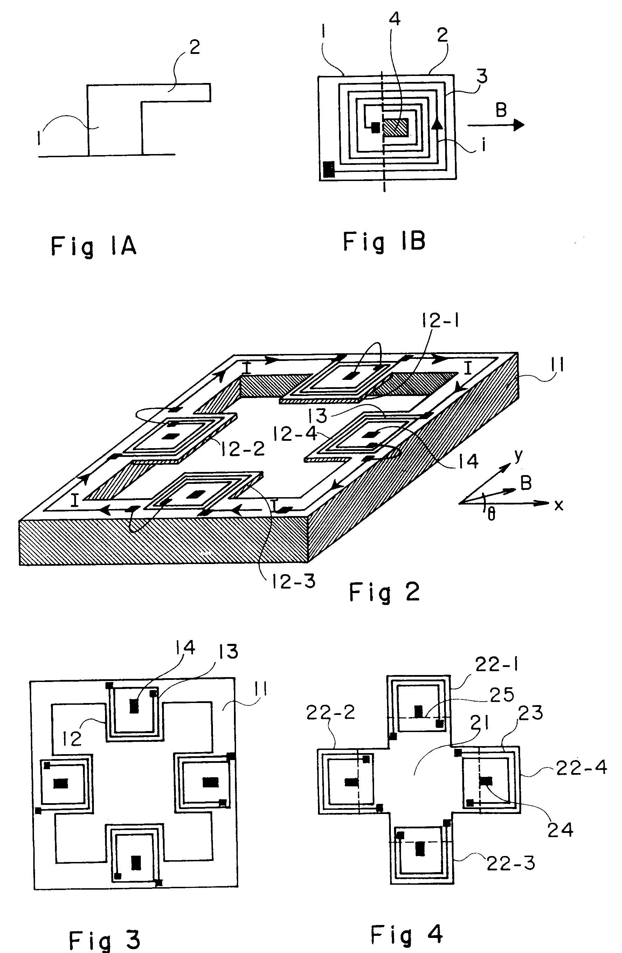

Les figures 1A et 1B de cette demande de brevet sont reproduites dans les figures 1A et 1B ci-jointes, qui sont respectivement une vue de côté et une vue de dessus d'un micro-magnétomètre à poutre fléchissante. Celui-ci comprend un pied de silicium 1 d'où part une aile de silicium 2. Le pied a par exemple une hauteur de l'ordre de 0,3 à 0,5 mm et l'aile une épaisseur de l'ordre de la dizaine de micromètres. Comme le représente la vue de dessus de la figure 1B, la surface supérieure du pied et de l'aile porte un enroulement 3 dans lequel on fait circuler un courant i qui peut être un courant continu ou un courant alternatif à la fréquence de résonance de vibration de l'aile 2. Sous l'effet d'un champ magnétique B situé dans le plan de la face supérieure du capteur, l'aile 2 fléchit sous l'effet des forces de Laplace et cette déformation est détectée par un capteur piézoélectrique 4. Divers développements sont donnés dans cette demande de brevet sur des modes de réalisation du capteur piézoélectrique et des modes de détection de la déformation, par exemple à l'aide d'un enroulement de compensation créant un champ de contre-réaction, cet enroulement étant disposé sur le socle sur lequel est fixé le pied 1, en regard de l'aile 2.

La présente invention prévoit d'utiliser un assemblage monolithique de capteurs du type de celui de la figure 1 dans lequel plusieurs ailes orientées dans des directions différentes s'étendent à partir d'un même support dont elles sont solidaires.

Plus particulièrement, la présente invention prévoit un détecteur angulaire de champ magnétique comprenant au moins deux capteurs à poutre fléchissante s'étendant dans des directions différentes et formés à partir d'un même support.

Selon un mode de réalisation de la présente invention, le détecteur comprend quatre capteurs à poutre fléchissante orthogonaux deux à deux.

Selon un mode de réalisation de la présente invention, chacun des capteurs s'étend vers l'extérieur à partir d'un même support central.

Selon un mode de réalisation de la présente invention, chacun des capteurs s'étend vers le centre d'un même support en forme de cadre.

Selon un mode de réalisation de la présente invention, les indications de chacun des couples de capteurs sont traitées de façon à s'affranchir de la valeur absolue du champ.

Selon un mode de réalisation de la présente invention, le détecteur angulaire est placé dans l'entrefer d'un aimant tournant disposé en bout d'un axe dont on veut déterminer l'orientation angulaire.

Selon un mode de réalisation de la présente invention, le détecteur comprend en outre des moyens pour détecter une déformation simultanée de tous les capteurs élémentaires dans une même direction, d'où il résulte la détermination d'un état de choc. Ainsi le détecteur angulaire obtenu peut également servir de détecteur de choc, ce qui est particulièrement utile dans des applications automobiles où un tel détecteur est également généralement requis.

Ces objets, caractéristiques et avantages ainsi que d'autres de la présente invention seront exposés en détail dans la description suivante de modes de réalisation particuliers faite à titre non limitatif en relation avec les figures jointes parmi lesquelles :
les figures 1A et 1B, décrites précédemment, sont les figures 1A et 1B de la demande de brevet français 2 644 897 ;
la figure 2 est une vue en perspective d'un mode de réalisation d'un détecteur selon la présente invention ;
la figure 3 est une vue de dessus schématique du mode de réalisation de la figure 2 ;
la figure 4 est une vue de dessus schématique d'un autre mode de réalisation de la présente invention ;
la figure 5 est une vue en coupe schématique d'un ensemble de mesure d'angle incluant un détecteur selon la présente invention ; et
la figure 6 représente un exemple de circuit électrique de détection utilisable en relation avec le détecteur selon la présente invention.

La figure 2 est une vue en perspective d'un mode de réalisation d'un détecteur selon la présente invention. Ce détecteur comprend un cadre en silicium 11 de forme générale carrée à partir duquel s'étendent vers l'intérieur quatre ailes en silicium 12-1, 12-2, 12-3, 12-4. Cet ensemble est obtenu de façon classique, comme cela a été décrit par exemple en relation avec la demande de brevet susmentionnée, par photolithogravure d'une tranche de silicium monocristallin, plusieurs ensembles tels que celui de la figure 2 étant formés simultanément à partir d'une même tranche de silicium.

Un avantage de cette structure est que les angles entre les branches du cadre 11 et entre chacune de ces branches et la direction dans laquelle s'étendent les ailes 12 sont déterminés avec une extrême précision correspondant à la précision d'un masque de photolithogravure. On pourra donc avoir un cadre parfaitement carré dans lequel les ailes s'étendent à 90° de chacune des branches.

Comme cela a été expliqué dans la demande de brevet susmentionnée, chacune des ailes porte un enroulement conducteur dont une branche est parallèle au bord externe de l'aile et dont la branche opposée est située sur le cadre. Ces enroulements sont désignés par la référence 13 et sont connectés en série avec une source de courant I. De même, sur chaque aile est formé un moyen de détermination de l'inclinaison de cette aile désigné par la référence 14, qui sera de préférence un moyen piézoélectrique tel que décrit dans la demande de brevet antérieure mais tout autre moyen approprié pourra être utilisé. Par exemple, comme cela est précisé dans la demande de brevet susmentionnée, on pourra former sur le support du détecteur de la figure 2 des enroulements de compensation.

Si l'on considère que les branches du cadre 11 sont respectivement parallèles à un axe x et à un axe y, les ailes 12-2 et 12-4 seront soumises à une force quand le champ appliqué B comprend une composante parallèle à l'axe x et les ailes 12-1 et 12-3 seront soumises à une force quand le champ magnétique appliqué comprend une composante parallèle à l'axe y. Ainsi, si le champ appliqué B, est orienté selon un angle ϑ par rapport à l'axe x, les forces appliquées aux ailes 12-2 et 12-4, d'une part, et 12-1 et 12-3, d'autre part, comprendront respectivement, outre une éventuelle composante continue, une composante proportionnelle à Bcosϑ et à Bsinϑ. On dispose donc ainsi d'un détecteur propre à déterminer avec précision l'angle ϑ entre la direction du champ et un axe de référence.

La figure 3 est une vue de dessus schématique correspondant à la vue en perspective de la figure 2.

La figure 4 est une vue de dessus représentant une variante de réalisation de la présente invention dans laquelle les quatre ailes 22-1, 22-2, 22-3 et 22-4 s'étendent à partir d'un pied central 21 et portent chacune une partie d'un enroulement 23 et un élément de détection piézoélectrique 24. Les traits en pointillés 25 désignent les limites entre chacune des ailes et le pied central. Comme dans le mode de réalisation précédent, la structure de la figure 4 est obtenue à partir d'une tranche de silicium monocristallin et les angles entre chacune des ailes sont fixés avec précision.

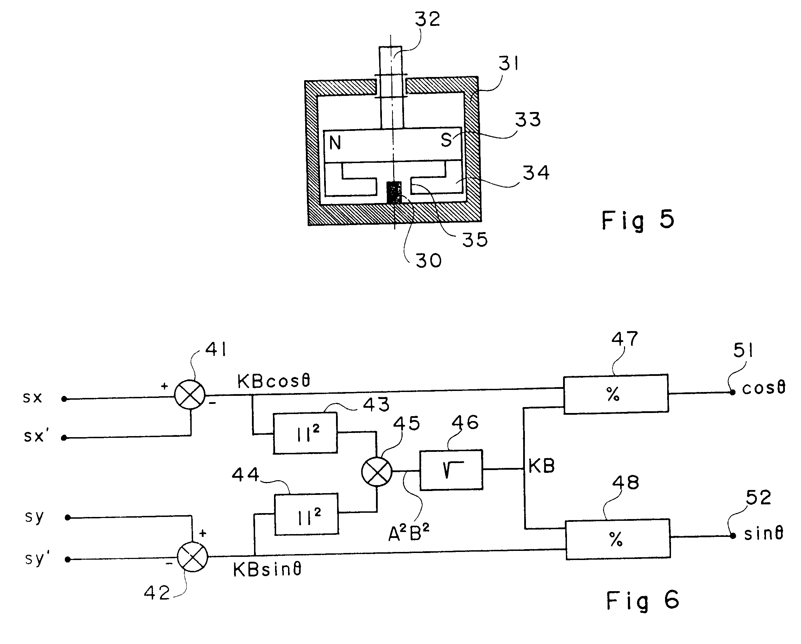

La figure 5 représente un exemple de montage d'un détecteur selon la présente invention. Ce détecteur, désigné par la référence 30, est disposé à l'intérieur d'un boîtier 31 traversé par un axe 32 dont on veut déterminer la position angulaire. Cet axe est lié à un aimant 33 dont les pôles nord et sud, N et S, sont prolongés par des pièces magnétiques 34 qui viennent de part et d'autre du détecteur 30. Ainsi, l'orientation du champ entre les extrémités 35 des pièces polaires 34 reflètera l'orientation de l'axe 32 et sera détectée par le détecteur 30.

La figure 6 représente un exemple de circuit de mesure de l'orientation angulaire d'un champ par rapport au détecteur selon l'invention. Ce circuit comprend quatre entrées, sx, sx', sy, sy', respectivement associées aux ailes 12-2, 12-4, 12-1 et 12-3. Les signaux correspondants ont par exemple respectivement les valeurs :
sx = S₀+ KBcosϑ,
sx' = s₀ - KBcosϑ,
sy = s₀ + KBsinϑ, et
sy' = s₀ - KBsinϑ.
Où s₀ et K sont des constantes. Les signaux sx et sx' sont envoyés à un premier sommateur 41 qui fournit la différence sx-sx' et les signaux sy et sy' sont envoyés à un second sommateur 42 qui fournit la différence sy-sy', c'est-à-dire que l'on obtient à la sortie de ces sommateurs des signaux respectifs KBcosϑ et KBsinϑ. Chacun de ces signaux est envoyé à un circuit d'élévation au carré respectif 43, 44 dont les sorties sont envoyées à un sommateur 45 où l'on obtient donc une valeur proportionnelle à B². Un circuit 46 fournit la racine carrée de cette valeur, c'est-à-dire la valeur KB. Un premier diviseur 47 reçoit la sortie du sommateur 41 et la sortie du circuit 46 et divise sa première entrée par sa deuxième pour fournir sur sa sortie 51 la valeur cosϑ. De même, un second diviseur 48 reçoit les sorties du sommateur 42 et du circuit 46 et fournit sur sa sortie 52 un signal sinϑ. On obtient ainsi sur les sorties 51 et 52, des valeurs proportionnelles au sinus et au cosinus de l'angle ϑ d'orientation du champ par rapport à un axe de référence x. Ces valeurs étant indépendantes de la valeur du champ, le système selon la présente invention ne nécessite pas de circuit d'étalonnage. En outre, on notera que dans le mode de réalisation d'un détecteur complet tel qu'illustré en figure 5, le fait que la cellule 30 soit décentrée par rapport aux pièces polaires 34 n'entraîne pas de distorsions de mesure. De même, des variations d'intensité de l'aimant permanent 33 seront sans effet.

On notera que le détecteur selon la présente invention peut en outre servir de détecteur de choc. En effet, lors d'un choc, toutes les ailes plieront sensiblement de la même valeur et les signaux sx, sx', sy, sy' seront tous égaux. On obtiendra donc sur les sorties 51 et 52 des valeurs nulles indicatives d'un choc. Un circuit spécifique d'analyse du signal d'un couple de capteurs est prévu, si on le souhaite, pour déterminer les caractéristiques du choc.

Bien entendu, la présente invention est susceptible de nombreuses variantes et modifications qui apparaitront à l'homme de l'art. Par exemple, on a décrit ci-dessus un détecteur à quatre capteurs, deux à deux parallèles. En fait, deux capteurs seulement seraient nécessaires, l'utilisation de quatre capteurs étant préférée seulement parce qu'elle simplifie la réalisation du circuit électronique et permet d'éviter la prévision de circuits de compensation complexes. Un nombre de capteurs supérieur à quatre pourrait aussi être utilisé, par exemple pour réaliser des compensations supplémentaires. Dans le cas de structures du type de celle de la figure 2, une aile supplémentaire pourrait être disposée de l'autre coté du cadre symétriquement par rapport à chacune des ailes existantes. Egalement, on pourrait prévoir des structures hexagonales puisque que l'on peut facilement obtenir de telles structures par gravure d'une tranche de silicium monocristallin dont les axes sont convenablement orientés.

## Revendications

1. Détecteur angulaire de champ magnétique caractérisé en ce qu'il comprend au moins deux capteurs à poutre fléchissante (12) s'étendant dans des directions différentes et formés à partir d'un même support (11 ; 21).

2. Détecteur angulaire de champ magnétique selon la revendication 1, caractérisé en ce qu'il comprend quatre capteurs à poutre fléchissante orthogonaux deux à deux.

3. Détecteur angulaire de champ magnétique selon la revendication 2, caractérisé en ce que chacun des capteurs (22-1...22-4) s'étend vers l'extérieur à partir d'un même support central (21).

4. Détecteur angulaire de champ magnétique selon la revendication 2, caractérisé en ce que chacun des capteurs (12-1...12-4) s'étend vers le centre d'un même support (11) en forme de cadre.

5. Détecteur angulaire de champ magnétique selon l'une quelconque des revendications 2 à 4, caractérisé en ce que les indications de chacun des couples de capteurs sont traitées de façon à s'affranchir de la valeur absolue du champ.

6. Détecteur angulaire de champ magnétique selon l'une quelconque des revendications 1 à 5, caractérisé en ce qu'il est placé dans l'entrefer d'un aimant tournant disposé en bout d'un axe (32) dont on veut déterminer l'orientation angulaire.

7. Détecteur angulaire de champ magnétique selon l'une quelconque des revendications 2 à 6, caractérisé en ce qu'il comprend en outre des moyens pour détecter une déformation simultanée de tous les capteurs élémentaires dans une même direction, d'où il résulte la détermination d'un état de choc.
